# EUROPEAN PATENT SPECIFICATION

(11) **EP 4 582 213 B1**
(45) Date of publication and mention of the grant of the patent: **18.11.2026**
(21) Application number: 24829012.4
(22) Date of filing: 02.08.2024
(51) Int. Cl.: B23K 26/364, H10F 71/00, H10F 10/165, H10F 77/30

(54) **METHOD FOR PREPARING TOPCON SOLAR CELL SUBSTRATE**
VERFAHREN ZUR HERSTELLUNG EINES TOPCON-SOLARZELLENSUBSTRATS
PROCÉDÉ DE PRÉPARATION D'UN SUBSTRAT DE CELLULE SOLAIRE TOPCON

(30) Priority: 25.10.2023 CN 202311394254
(43) Date of publication of application: 09.07.2025
(73) Proprietor: Huansheng Photovoltaic (Jiangsu) Co., Ltd, Yixing Wuxi, Jiangsu 214203 (CN)
(72) Inventor: TANG, Yiwu, Yixing Wuxi, Jiangsu 214203 (CN); LI, Suqiang, Yixing Wuxi, Jiangsu 214203 (CN); LI, Kewei, Yixing Wuxi, Jiangsu 214203 (CN); GUANG, Tongzhou, Yixing Wuxi, Jiangsu 214203 (CN); YU, Chao, Yixing Wuxi, Jiangsu 214203 (CN); SONG, Nan, Yixing Wuxi, Jiangsu 214203 (CN); WANG, Peng, Yixing Wuxi, Jiangsu 214203 (CN); WANG, Yan, Yixing Wuxi, Jiangsu 214203 (CN)
(74) Representative: Cristinelli, Luca
(86) International application number: PCT/CN2024/109546
(87) International publication number: WO 2025/086782

(56) References cited:
- WO-A1-2021/087331
- CN-A- 110 739 366
- CN-A- 111 987 191
- CN-A- 114 447 156
- CN-A- 115 148 858
- CN-A- 116 207 169
- CN-A- 116 805 655
- CN-A- 117 410 379
- JP-A- 2011 249 780
- GRÜBEL BENJAMIN ET AL: "Progress of plated metallization for industrial bifacial TOPCon silicon solar cells", PROGRESS IN PHOTOVOLTAICS: RESEARCH AND APPLICATIONS, vol. 30, no. 6, 20 December 2021 (2021-12-20), Hoboken, USA, pages 615 - 621, XP093118313, ISSN: 1062-7995, DOI: 10.1002/pip.3528
- CHEN RAN ET AL: "24.58% efficient commercial n-type silicon solar cells with hydrogenation", PROGRESS IN PHOTOVOLTAICS: RESEARCH AND APPLICATIONS, vol. 29, no. 11, 12 September 2021 (2021-09-12), Hoboken, USA, pages 1213 - 1218, XP093332107, ISSN: 1062-7995, [retrieved on 20251104], DOI: 10.1002/pip.3464
- ARYA VARUN ET AL: "TOPCon Solar Cells: Laser Ablation and Contact Formation Strategies", 2020 47TH IEEE PHOTOVOLTAIC SPECIALISTS CONFERENCE (PVSC), IEEE, 15 June 2020 (2020-06-15), pages 401 - 404, XP033870904, DOI: 10.1109/PVSC45281.2020.9300469
- FIRAT MERI? ET AL: "Industrial metallization of fired passivating contacts for n-type tunnel oxide passivated contact (n-TOPCon) solar cells", SOLAR ENERGY MATERIALS AND SOLAR CELLS, ELSEVIER SCIENCE PUBLISHERS, AMSTERDAM, NL, vol. 240, 10 March 2022 (2022-03-10), XP087019346, ISSN: 0927-0248, [retrieved on 20220310], DOI: 10.1016/J.SOLMAT.2022.111692
- HOMBURG O ET AL: "Gaussian-to-top-hat beam shaping: an overview of parameters, methods, and applications", LASER RESONATORS, MICRORESONATORS, AND BEAM CONTROL XIV, SPIE, 1000 20TH ST. BELLINGHAM WA 98225-6705 USA, vol. 8236, no. 1, 9 February 2012 (2012-02-09), pages 1 - 9, XP060001726, DOI: 10.1117/12.907914

## Description

### CROSS-REFERENCE TO RELATED APPLICATIONS

The present invention claims priority to Chinese Patent Application No. 202311394254.1 entitled "METHOD FOR IMPROVING OPEN CIRCUIT VOLTAGE OF DOUBLE-SIDED ELECTROPLATED TOPCon BATTERY AND BATTERY COMPONENT PREPARED THEREFROM" filed with Chinese Patent Office on October 25, 2023.

### TECHNICAL FIELD

The present invention relates to the technical field of TOPCon (Tunnel Oxide Passivated Contact) solar cells, in particular to a method for preparing TOPCon solar cell substrate.

### BACKGROUND

At present, in terms of the technical level of TOPCon solar cells, the cost of silver paste used in the traditional screen printing process is high, and it is difficult to effectively improve the height-width ratio of the prepared front finger. Compared with this technology, TOPCon solar cell prepared by horizontal double-sided electroplating has the following advantages: increasing the height-width ratio of the front finger; and reducing the width of the finger and increasing the light exposed area of the battery. Moreover, double-sided electrodes mainly rely on copper to conduct electricity, which is cheap and achieves the purpose of reducing the production cost of batteries.

However, the traditional grooving method of double-sided electroplated TOPCon solar cell is to directly groove silicon nitride by using a laser to expose the underneath silicon, thus ensuring that the electroplating process can be carried out, wherein the preparation process is: laser grooving on the front side → laser grooving on the back side → electroplating. In this grooving process, since the back side is a smooth polished surface, laser grooving causes little damage to the silicon substrate. However, the front side is a texturing surface with pyramid structure, if the silicon nitride film on the surface is removed by laser, it will inevitably cause some damage to the silicon substrate, which may destroy the PN junctions on the silicon substrate, resulting in the loss of the open circuit voltage of the battery sheet, thus leading to the reduction of the conversion efficiency of the final electroplated battery. Generally, the open circuit voltage loss caused by laser damage of double-sided electroplated TOPCon cells is about 10~20 mV, reflected in the efficiency of solar cells, and the efficiency loss is about 1~1.5%.

Therefore, it is urgent to develop a method to minimize the open circuit voltage loss caused by laser damage of double-sided electroplated TOPCon solar cell.

As set forth in Grübel Benjamin ET AL.: "Progress of plated metallization for industrial bifacial TOPCon silicon solar cells", Progress in Photovoltaics: Research and Applications, vol. 30, no. 6, 20 December 2021, pages 615-621, XP093118313 (hereinafter referred to as Grübel Benjamin ET AL.), which discloses plated metallization processes for industrial bifacial TOPCon silicon solar cells, the cell structure features a rear side with a tunnel SiOₓ, n-type doped polysilicon layer, and SiNₓ passivation layer, while the front side consists of a boron emitter passivated by an AlOₓ/SiNₓ stack. Grübel Benjamin ET AL. describe that the antireflective coating on both the front and rear sides was laser-ablated (see Fig.1 & Section 2.1) to enable subsequent Ni/Cu/Ag plating. Additionally, precursors were fired in a fast-firing oven (FFO), and such high-temperature treatments were shown to recover laser-induced damage (see Section 2.1)

### SUMMARY

The present invention provides a method according to claim 1 for preparing TOPcon solar cell substrate.

In order to achieve at least one of the above objectives of the present invention, the following technical solution is adopted.

In the first aspect, the present invention provides a method for preparing a TOPCon solar cell substrate, which includes the following steps:
providing a double-sided grooved silicon matrix of a TOPCon solar cell;
applying thermal repair treatment to the silicon matrix;
performing light injection treatment on the front side and the back side of the silicon matrix after the thermal repair treatment, respectively, thereby obtaining a TOPCon solar cell substrate.

In a second aspect, there is described a solar cell substrate, wherein the TOPCon solar cell substrate is rendered by using the method as described above.

In a third aspect, there is described a double-sided electroplated TOPCon solar cell, wherein the double-sided electroplated TOPCon solar cell is rendered by performing double-sided electroplating treatment on the TOPCon solar cell substrate as described above.

### DETAILED DESCRIPTION OF THE EMBODIMENTS

Embodiments of the present invention will be described in detail below with reference to examples, but those skilled in the art will understand that the following examples are only used to illustrate the present invention and should not be regarded as limiting the scope of the present invention. Where specific conditions are not specified in the examples, it shall be carried out according to the conventional conditions or the conditions suggested by the manufacturer.

In a first aspect, the present invention provides a method for preparing a TOPCon solar cell substrate.

In the present invention, a method for preparing a TOPCon solar cell substrate includes:
providing a double-sided grooved silicon matrix of a TOPCon solar cell;
carrying out thermal repair treatment on the silicon matrix;
respectively performing light injection treatment on the front side and the back side of the silicon matrix after thermal repair treatment, thereby obtaining a TOPCon solar cell substrate.

In present invention, firstly, the double-side grooved silicon matrix of TOPCon solar cell is treated by thermal repair, which can greatly increase the overall lattice thermal motion of the silicon substrate; then, light is injected into the front side and the back side in the directions of two different light incidence surfaces, so that both the front side and the back side can absorb light, thereby repairing the defects at the interface between the amorphous silicon and the silicon wafer and improving the quality of the PN junctions. After thermal repair and double-sided light injection, the open circuit voltage after horizontal double-sided electroplating can be improved by 4~10 mV and the photoelectric conversion efficiency can be improved by 0.2~0.8%.

Further, the double-sided grooved silicon matrix of the TOPCon solar cell is prepared by the following steps:
(a) depositing a passivation film on the surface of a silicon matrix of a TOPCon solar cell to form a coating layer; and
(b) removing the coating layers on the front and back sides of the silicon matrix by using a laser grooving method, to form a grid line pattern on the surfaces of the coating layers.

Further, in step (a), the passivation film is a silicon nitride film.

Further, in step (a), the thickness of the passivation film is 80-100 nm, for example, may be 80 nm, 82 nm, 84 nm, 86 nm, 88 nm, 90 nm, 92 nm, 94 nm, 96 nm, 98 nm, 100 nm, and the like.

Further, in step (b), the laser for laser grooving is an ultraviolet picosecond laser or an ultraviolet nanosecond laser.

Further, in step (b), the laser beam of the laser for laser grooving is a top-hat beam.

In present invention, by using the top-hat beam laser for grooving, the spot energy is very uniform, the passivation film in the middle and at the edge can be completely removed, and the damage to the front PN junctions is smaller.

Further, in step (b), the laser peak power in the process of laser grooving is 0.5-2 W, which may be, for example, 0.5 W, 0.6 W, 0.8 W, 1 W, 1.2 W, 1.4 W, 1.6 W, 1.8 W, 2 W, and the like.

Further, in step (b), the grooving width of the finger in the grid line pattern formed after laser grooving is 10-15 µm, which may be, for example, 10 µm, 10.5 µm, 11 µm, 11.5 µm, 12 µm, 12.5 µm, 13 µm, 13.5 µm, 14 µm, 14.5 µm, 15 µm, and the like.

Further, in step (b), the grooving depth in the grid line pattern formed after laser grooving is 80-100 nm, which may be, for example, 80 nm, 82 nm, 84 nm, 86 nm, 88 nm, 90 nm, 92 nm, 94 nm, 96 nm, 98 nm, 100 nm, and the like.

Further, in step (b), the auxiliary gas for laser grooving is any one selected from nitrogen, argon and helium, preferably nitrogen and/or argon.

Further, the thermal repair treatment specifically includes the following steps.

The double-sided grooved silicon matrix of TOPCon solar cell was placed with the front side upward in the atmosphere of protective gas for thermal repair treatment.

Further, the protective gas is nitrogen.

Further, the flow rate of nitrogen is 20~30 L/min, for example, which may be, 20 L/min, 21 L/min, 22 L/min, 23 L/min, 24 L/min, 25 L/min, 26 L/min, 27 L/min, 28 L/min and 29 L/min, 30 L/min, and the like.

Further, the temperature of the thermal repair treatment is 600~800°C, for example, which may be, 600°C, 620°C, 640°C, 660°C, 680°C, 700°C, 720°C, 740°C, 760°C, 780°C, 800°C, and the like.

Further, the duration of the thermal repair treatment is 120~180 s, for example, which may be, 120 s, 125 s, 130 s, 135 s, 140 s, 145 s, 150 s, 155 s, 160 s, 165 s, 170 s, 175 s, 180s, and the like.

Further, the light injection treatment specifically includes the following steps.

Firstly, one side of the silicon matrix after thermal repair treatment is upward, and light injection treatment is carried out in the atmosphere of protective gas; then it is turned over to make the other side upwards, and placed in the atmosphere of protective gas for light injection treatment to render the treated TOPCon solar cell substrate.

In present invention, the front-side light injection processing can be performed first, and then the reverse-side light injection processing can be performed by turning over; or the reverse-side light injection treatment is carried out first, and then the front-side light injection treatment is carried out by turning over.

Further, the protective gas is any one of nitrogen, argon and helium, preferably nitrogen.

Further, the flow rate of the protective gas is 10~15 L/min, for example, which may be, 10 L/min, 10.5 L/min, 11 L/min, 11.5 L/min, 12 L/min, 12.5 L/min, 13 L/min, 13.5 L/min, 14 L/min, 14.5 L/min, 15 L/min, and the like.

Further, heating is needed during the light injection treatment.

Further, the heating temperature is 200~300°C, such as 200°C, 210°C, 220°C, 230°C, 240°C, 250°C, 260°C, 270°C, 280°C, 290°C, 300°C, and the like.

Further, the light radiation intensity of the light injection treatment is 10~30 sun, such as 10 sun, 12 sun, 14 sun, 16 sun, 18 sun, 20 sun, 22 sun, 24 sun, 26 sun, 28 sun, 30 sun, and the like.

Further, the duration of the light injection treatment is 60~120 s, such as 60 s, 65 s, 70 s, 75 s, 80 s, 85 s, 90s, 95 s, 100 s, 105 s, 110 s, 115th, 120s, and the like.

Further, the light source of the light injection treatment is white light and/or infrared light.

As a preferred technical solution of the present invention, the method for improving the open circuit voltage of a double-sided electroplated TOPCon solar cell specifically includes the following steps.

S1, Laser grooving
(a) depositing a silicon nitride passivation film of 80~100 nm on the surface of a silicon matrix of a TOPCon solar cell to render a coating layer; and
(b) sequentially removing the coating layers on the front and back sides of the silicon matrix by a laser grooving method, and forming a grid line pattern on the surface of the coating layer,
wherein the laser of the laser grooving is an ultraviolet picosecond laser or an ultraviolet nanosecond laser; and the laser beam of the laser for laser grooving is a top-hat beam.

S2, Thermal repair treatment
placing the double-sided grooved silicon matrix of TOPCon solar cell with the front side upward in a nitrogen atmosphere for thermal repair treatment,
wherein the flow rate of the nitrogen is 20~30 L/min; the temperature of thermal repair treatment is 600 ~ 800°C; and the duration of thermal repair treatment is 120 ~ 180 s.

S3, Double-sided light injection treatment
making, firstly, one side of the silicon matrix after high-temperature thermal repair treatment upward, and placing it in a nitrogen atmosphere for light injection treatment; then, turning it over to make the other side upwards, and placing it in the atmosphere of nitrogen for light injection treatment, supplemented with heating to realize passivation, so as to render the treated TOPCon solar cell substrate,
wherein the flow rate of nitrogen is 10~15 L/min; the heating temperature is 200~300°C; the light radiation intensity of light injection treatment is 10~30 sun; the duration of light injection treatment is 60~120 s.

In the second aspect, there is described a TOPCon solar cell substrate, which is rendered by the method as described above of improving the open circuit voltage of the double-sided electroplated TOPCon cell.

In a third aspect, there is described a double-sided electroplated TOPCon solar cell, which is rendered by double-sided electroplating for the TOPCon solar cell substrate.

Further, the double-sided electroplating treatment includes any one or a combination of at least two of nickel electroplating, copper electroplating and tin electroplating, preferably a combination of nickel electroplating, copper electroplating and tin electroplating.

Further, the horizontal double-sided electroplating is to sequentially electroplate three metals, namely nickel, copper and tin, on the front and back sides of the battery sheet after light injection to render a double-sided electroplated TOPCon solar cell.

Embodiments of the present invention will be described in detail below with reference to examples, but those skilled in the art will understand that the following examples are only used to illustrate the present invention and should not be regarded as limiting the scope of the present invention. Where specific conditions are not specified in the examples, it shall be carried out according to the conventional conditions or the conditions suggested by the manufacturer.

To facilitate a clearer understanding of the contents of the present invention, specific examples are now described in detail as follows. However, these examples are only exemplary and do not constitute any limitation on the scope of the present invention.

### Example 1

This example provided a method for improving the open circuit voltage of a double-sided electroplated TOPCon solar cell, which specifically included the following steps.

S1, Laser grooving
(a) A 90 nm silicon nitride passivation film was deposited on the surface of a silicon matrix of a TOPCon solar cell to render a coating layer.
(b) The coating layers on the front and back sides of the silicon matrix were sequentially removed by a laser grooving method, and a grid line pattern on the surface of the coating layer was formed.

The laser of the laser grooving was an ultraviolet picosecond laser; the laser beam of the laser for laser grooving was a top-hat beam; and the laser peak power in the laser grooving process was 1 W.

The grooving width of the finger in the grid line pattern formed after laser grooving was 12 µm; and the grooving depth was 90 nm.

The auxiliary gas of the laser grooving was nitrogen.

### S2, High-temperature thermal repair treatment

The double-sided grooved silicon matrix of TOPCon solar cell was placed with the front side upward in a nitrogen atmosphere for high-temperature thermal repair treatment.

The flow rate of the nitrogen gas was 25 L/min; the temperature of high-temperature thermal repair treatment was 700°C; and the duration of high-temperature thermal repair treatment was 150 s.

### S3, Double-sided light injection treatment

Firstly, the back side of the silicon matrix after high-temperature thermal repair treatment was upward, and placed in a nitrogen atmosphere for light injection treatment; then it was turned over to make the front side upwards, and placed in nitrogen atmosphere for light injection treatment, supplemented by heating to realize passivation, such that the treated TOPCon solar cell substrate was obtained.

The flow rate of nitrogen was 12 L/min; the heating temperature was 250°C; the light radiation intensity of light injection treatment was 20 sun; the duration of light injection treatment was 90 s; and the light source of the light injection treatment was white light.

### Example 2

This example provided a method for improving the open circuit voltage of a double-sided electroplated TOPCon solar cell, which specifically included the following steps.

S1, Laser grooving
(a) An 80 nm silicon nitride passivation film was deposited on the surface of a silicon matrix of a TOPCon solar cell to render a coating layer.
(b) The coating layers on the front and back sides of the silicon matrix were sequentially removed by a laser grooving method, and a grid line pattern on the surface of the coating layer was formed.

The laser of the laser grooving was an ultraviolet picosecond laser; the laser beam of the laser for laser grooving was a top-hat beam; the laser peak power in the laser grooving process was 0.5 W.

The grooving width of the finger in the grid line pattern formed after laser grooving was 10 µm; and the grooving depth was 80 nm.

The auxiliary gas of the laser grooving was argon.

### S2, High-temperature thermal repair treatment

The double-sided grooved silicon matrix of TOPCon solar cell was placed with the front side upward in a nitrogen atmosphere for high-temperature thermal repair treatment.

The flow rate of the nitrogen gas was 20 L/min; the temperature of high-temperature thermal repair treatment was 600°C; and the duration of high-temperature thermal repair treatment was 180 s.

### S3, Double-sided light injection treatment

Firstly, the back side of the silicon matrix after high-temperature thermal repair treatment was upward, and placed in a nitrogen atmosphere for light injection treatment; then it was turned over to make the front side upwards, and placed in nitrogen atmosphere for light injection treatment, supplemented by heating to realize passivation, such that the treated TOPCon solar cell substrate was obtained.

The flow rate of nitrogen was 10 L/min; the heating temperature was 300°C; the light radiation intensity of light injection treatment was 10 sun; the duration of light injection treatment was 120 s; and the light source of the light injection treatment was infrared light.

### Example 3

This example provided a method for improving the open circuit voltage of a double-sided electroplated TOPCon solar cell, which specifically included the following steps.

S1, Laser grooving
(a) A 100 nm silicon nitride passivation film was deposited on the surface of a silicon matrix of a TOPCon solar cell to render a coating layer.
(b) The coating layers on the front and back sides of the silicon matrix were sequentially removed by a laser grooving method, and a grid line pattern on the surface of the coating layer was formed.

The laser of the laser grooving was an ultraviolet nanosecond laser; the laser beam of the laser for laser grooving was a top-hat beam; and the laser peak power in the laser grooving process was 2 W.

The grooving width of the finger in the grid line pattern formed after laser grooving was 15 µm; and the grooving depth was 100 nm.

The auxiliary gas of the laser grooving was nitrogen.

### S2, High-temperature thermal repair treatment

The double-sided grooved silicon matrix of TOPCon solar cell was placed with the front side upwards in a nitrogen atmosphere for high-temperature thermal repair treatment.

The flow rate of the nitrogen gas was 30 L/min; the temperature of high-temperature thermal repair treatment was 800°C; and the duration of high-temperature thermal repair treatment was 120 s.

### S3, Double-sided light injection treatment

Firstly, the back side of the silicon matrix after high-temperature thermal repair treatment was upward, and placed in a nitrogen atmosphere for light injection treatment; then it was turned over to make the front side upwards, and placed in nitrogen atmosphere for light injection treatment, supplemented by heating to realize passivation, such that the treated TOPCon solar cell substrate was obtained.

The flow rate of nitrogen was 15 L/min; the heating temperature was 200°C; the light radiation intensity of light injection treatment was 30 sun; the duration of light injection treatment was 60 s; and the light source of the light injection treatment was white light.

### Example 4

This example provided a method for increasing the open circuit voltage of a double-sided electroplated TOPCon solar cell, differed from Example 1 only in that the laser beam of the laser for laser grooving was Gaussian beam, and other steps were exactly the same as Example 1.

### Example 5

This example provided a method for increasing the open circuit voltage of a double-sided electroplated TOPCon solar cell, differed from Example 1 only in that the laser peak power in the laser grooving process was 0.1 W, and other steps were exactly the same as Example 1.

### Example 6

This example provided a method for increasing the open circuit voltage of a double-sided electroplated TOPCon solar cell, differed from Example 1 only in that the laser peak power in the laser grooving process was 2.5 W, and other steps were exactly the same as Example 1.

### Example 7

This example provided a method for increasing the open circuit voltage of a double-sided electroplated TOPCon solar cell, differed from Example 1 only in that the double-sided grooved silicon matrix of TOPCon solar cell was placed with the front side upward in the atmosphere of protective gas for high-temperature thermal repair treatment; then it was turned over to make the other side upwards, and placed in the atmosphere of protective gas for high-temperature thermal repair treatment; and other steps were exactly the same as Example 1.

### Example 8

This example provided a method for increasing the open circuit voltage of a double-sided electroplated TOPCon solar cell, differed from Example 1 only in that the temperature of the high-temperature thermal repair treatment was 580°C, the duration of the high-temperature thermal repair treatment was 200s, and other steps were exactly the same as Example 1.

### Example 9

This example provided a method for increasing the open circuit voltage of a double-sided electroplated TOPCon solar cell, differed from Example 1 only in that the temperature of the high-temperature thermal repair treatment was 820°C, the duration of the high-temperature thermal repair treatment was 100s, and other steps were exactly the same as Example 1.

### Example 10

This example provided a method for increasing the open circuit voltage of a double-sided electroplated TOPCon solar cell, differed from Example 1 only in that no heating treatment was carried out during the light injection treatment, and other steps were exactly the same as Example 1.

### Example 11

This example provided a method for increasing the open circuit voltage of a double-sided electroplated TOPCon solar cell, differed from Example 1 only in that the light radiation intensity of light injection treatment was 5 sun; the duration of light injection treatment was 150 s; and other steps were exactly the same as Example 1.

### Example 12

This example provided a method for increasing the open circuit voltage of a double-sided electroplated TOPCon solar cell, differed from Example 1 only in that the light radiation intensity of light injection treatment was 35 sun; the duration of light injection treatment was 50 s; and other steps were exactly the same as Example 1

### Comparative Example 1

This Comparative Example provided a TOPCon solar cell substrate, which was prepared by the following method.
(a) A 90 nm silicon nitride passivation film was deposited on the surface of a silicon matrix of a TOPCon solar cell to render a coating layer.
(b) The coating layers on the front and back sides of the silicon matrix were sequentially removed by a laser grooving method, and a grid line pattern on the surface of the coating layer was formed.

The laser of the laser grooving was an ultraviolet picosecond laser; the laser beam of the laser for laser grooving was a top-hat beam; and the laser peak power in the laser grooving process was 1 W.

The grooving width of the finger in the grid line pattern formed after laser grooving was 12 µm; and the grooving depth was 90 nm.

The auxiliary gas of the laser grooving was nitrogen.

### Comparative Example 2

This Comparative Example provided a method for improving the open circuit voltage of a double-sided electroplated TOPCon solar cell, which specifically included the following steps.

S1, Laser grooving
(a) A 90 nm silicon nitride passivation film was deposited on the surface of a silicon matrix of a TOPCon solar cell to render a coating layer.
(b) The coating layers on the front and back sides of the silicon matrix were sequentially removed by a laser grooving method, and a grid line pattern on the surface of the coating layer was formed.

The laser of the laser grooving was an ultraviolet picosecond laser; the laser beam of the laser for laser grooving was a top-hat beam; and the laser peak power in the laser grooving process was 1 W.

The grooving width of the finger in the grid line pattern formed after laser grooving was 12 µm; and the grooving depth was 90 nm.

The auxiliary gas of the laser grooving was nitrogen.

### S2, Double-sided light injection treatment

Firstly, the back side of the silicon matrix after grooved was upward, and placed in a nitrogen atmosphere for light injection treatment; then it was turned over to make the front side upward, and placed in nitrogen atmosphere for light injection treatment, supplemented by heating to realize passivation, such that the treated TOPCon solar cell substrate was obtained.

The flow rate of nitrogen was 12 L/min; the heating temperature was 250°C; the light radiation intensity of light injection treatment was 20 sun; the duration of light injection treatment was 90 s; and the light source of the light injection treatment was white light.

### Comparative Example 3

This Comparative Example provided a method for increasing the open circuit voltage of a double-sided electroplated TOPCon solar cell, which specifically included the following steps.

S1, Laser grooving
(a) A 90 nm silicon nitride passivation film was deposited on the surface of a silicon matrix of a TOPCon solar cell to render a coating layer.
(b) The coating layers on the front and back sides of the silicon matrix were sequentially removed by a laser grooving method, and a grid line pattern on the surface of the coating layer was formed.

The laser of the laser grooving was an ultraviolet picosecond laser; the laser beam of the laser for laser grooving was a top-hat beam; and the laser peak power in the laser grooving process was 1 W.

The grooving width of the finger in the grid line pattern formed after laser grooving was 12 µm; and the grooving depth was 90 nm.

The auxiliary gas of the laser grooving was nitrogen.

### S2, High-temperature thermal repair treatment

The double-sided grooved silicon matrix of TOPCon solar cell was placed with the front side upwards in a nitrogen atmosphere for high-temperature thermal repair treatment to render the treated TOPCon solar cell substrate.

The flow rate of the nitrogen gas was 25 L/min; the temperature of high-temperature thermal repair treatment was 700°C; and the duration of high-temperature thermal repair treatment was 150 s.

### Comparative Example 4

This Comparative Example provided a method for increasing the open circuit voltage of a double-sided electroplated TOPCon solar cell, differed from Example 1 only in that only one side was subjected to light injection treatment, specifically: only the back side of the silicon matrix after high-temperature thermal repair treatment was upward, and the light injection treatment was performed in a nitrogen atmosphere; and heating was assisted to realize passivation, such that the treated TOPCon solar cell substrate was obtained.

### Comparative Example 5

This Comparative Example provided a method for increasing the open circuit voltage of a double-sided electroplated TOPCon solar cell, differed from Example 1 only in that only one side was subjected to light injection treatment, specifically: only the front side of the silicon matrix after high-temperature thermal repair treatment was upward, and the light injection treatment was performed in a nitrogen atmosphere; and heating was assisted to realize passivation, such that the treated TOPCon solar cell substrate was obtained.

### Test example

### Electrical performance test

Test samples: battery substrates treated by methods in Examples 1 to 12 and battery substrates treated by methods in Comparative Examples 1 to 5.

### Test method:

### (1) Preparation of double-sided electroplated TOPCon solar cell :

Nickel, copper and tin were electroplated on the front and back sides of the above battery samples in sequence to render a double-sided electroplated TOPCon solar cell.

The thickness of nickel layer was 1.0 µm; the thickness of copper layer was 9 µm; and the thickness of tin layer was 1.2 µm.

### (2) Test data:

Electrical performance (mainly photoelectric conversion efficiency and open circuit voltage): The battery (with a size of 210 mm) rendered in Example 1 was tested by IV test (test condition: 25°C, AM1.5G).

The specific test results were shown in Table 1 below:

**Table 1**

| SAMPLES | Eta(%) | Uoc(V) | Isc(A) | FF(%) | Rs(Ω) |
|---|---|---|---|---|---|
| Example 1 | 23.56 | 0.6985 | 18.24 | 82.78 | 0.00058 |
| Example 2 | 23.58 | 0.6986 | 18.28 | 82.84 | 0.00055 |
| Example 3 | 23.66 | 0.6998 | 18.38 | 83.31 | 0.00052 |
| Example 4 | 23.38 | 0.6955 | 18.13 | 82.67 | 0.00034 |
| Example 5 | 5.11 | 0.5564 | 16.41 | 22.91 | 0.02146 |
| Example 6 | 21.61 | 0.6762 | 17.41 | 81.18 | 0.00127 |
| Example 7 | 23.55 | 0.6983 | 18.27 | 82.81 | 0.00048 |
| Example 8 | 23.38 | 0.6968 | 18.12 | 82.25 | 0.00052 |
| Example 9 | 23.32 | 0.6971 | 18.18 | 82.34 | 0.00063 |
| Example 10 | 23.21 | 0.6942 | 17.98 | 81.34 | 0.00056 |
| Example 11 | 23.48 | 0.6972 | 18.19 | 82.48 | 0.00047 |
| Example 12 | 23.51 | 0.6975 | 18.22 | 82.55 | 0.00056 |
| Comparative Example 1 | 22.92 | 0.6895 | 17.56 | 82.32 | 0.00071 |
| Comparative Example 2 | 23.22 | 0.6945 | 18.05 | 81.76 | 0.00043 |
| Comparative Example 3 | 23.10 | 0.6931 | 17.92 | 82.23 | 0.00049 |
| Comparative Example 4 | 23.18 | 0.6941 | 18.01 | 82.17 | 0.00041 |
| Comparative Example 5 | 23.45 | 0.6975 | 18.34 | 82.56 | 0.00053 |

According to the test data in Table 1, it can be seen that the open circuit voltage of the double-sided electroplated TOPCon solar cell prepared by double-sided electroplating for the battery substrate treated by the method disclosed in present invention can be improved by 4~10 mV, and the photoelectric conversion efficiency can be improved by 0.2~0.8%. From the comparison between Example 1 and Comparative Examples 1~5, it can be seen that the high-temperature thermal repair disclosed in present invention can greatly increase the overall lattice thermal motion of the silicon substrate, and light is injected into the front side and the back side in the directions of two different light incidence surfaces, so that both the front side and the back side can absorb light, thereby the defects at the interface between the amorphous silicon and the silicon wafer are repaired and the quality of the PN junctions is improved.

From the comparison between Example 1 and Examples 5~6, it can be seen that the laser power of 0.1 W is small, which leads to the failure to open the passivation film, so the electroplated metal was difficult to be plated and the efficiency was poor, while the laser power of 2.5 W is too large, the open circuit voltage loss reaches more than 30 mV.

From the comparison between Example 1 and Examples 8~9, it can be seen that the temperature of high-temperature thermal repair treatment is preferably 600~800°C and the duration is preferably 120~180 s; otherwise, even if the time is prolonged while lowering the temperature, or the temperature is elevated while shortening the processing time, the open circuit voltage and efficiency will be reduced.

From the comparison between Example 1 and Example 10, it can be seen that heating treatment is needed in the process of light injection treatment, otherwise, if there is no heating temperature, only illumination is useless for improving the open circuit voltage.

From the comparison between Example 1 and Examples 11~12, it can be seen that the light radiation intensity of light injection treatment is 10~30 sun, and the duration is 60~120 s, which is helpful to further improve the efficiency in such ranges. Otherwise, even if the time is prolonged while reducing the light radiation intensity, or the light radiation intensity is elevated while shortening processing time, the efficiency of the battery will be reduced.

From the comparison between Example 1 and Comparative Examples 1-4, it can be seen that the collaborative mode of high-temperature thermal repair and double-sided light injection is adopted in present invention, which can better repair the defects at the interface between amorphous silicon and silicon wafer and improve the quality of PN junctions, thus the open circuit voltage and efficiency of the prepared battery are improved significantly.

Compared with the prior art, the present invention has the following beneficial effects.
(1) In present invention, the top-hat beam laser is used to groove, the spot energy is very uniform, the passivation film in the middle and at the edge can be completely removed, and the damage to the front PN junctions is smaller.
(2) In present invention, the high-temperature thermal repair can greatly increase the overall lattice thermal motion of the silicon substrate; and light is injected into the front side and the back side in the directions of two different light incidence surfaces, which makes both the front side and the back side absorb light, thereby repairing the defects at the interface between the amorphous silicon and the silicon wafer and improving the quality of the PN junctions.
(3) In present invention, after high-temperature thermal repair and double-sided light injection are carried out on the double-sided grooved semi-finished products, the open circuit voltage can be increased by 4~10 mV and the photoelectric conversion efficiency can be improved by 0.2-0.8% after horizontal double-sided electroplating.

Although the present invention has been illustrated and described with specific examples, it should be realized that many other changes and modifications can be made without departing from the scope of the present invention. Therefore, it means that all such changes and modifications falling within the scope of the present invention are included in the appended claims.

## Claims

1. A method for preparing a TOPCon solar cell substrate, **characterized by** comprising:
providing a double-sided grooved silicon matrix of a TOPCon solar cell;
carrying out a thermal repair treatment on the silicon matrix; and
performing a light injection treatment on a front side and a back side of the silicon matrix after the thermal repair treatment, respectively, thereby obtaining the TOPCon solar cell substrate;
the light injection treatment comprises following steps:
making, firstly, one side of the silicon matrix after the thermal repair treatment upward, and placing it in an atmosphere of protective gas for the light injection treatment; then, turning it over to make the other side upwards, and placing it in an atmosphere of protective gas for the light injection treatment, to render a treated TOPCon solar cell substrate; and
a heating is needed during the light injection treatment; and a heating temperature is 200~300°C.

2. The method according to claim 1, wherein the double-sided grooved silicon matrix of the TOPCon solar cell is prepared by following steps:
(a) depositing a passivation film on surfaces of the silicon matrix of the TOPCon solar cell to form coating layers; and
(b) removing the coating layers on the front side and the back side of the silicon matrix by using a laser grooving method, and forming a grid line pattern on the surfaces of the coating layers.

3. The method according to claim 2, wherein in step (a), the passivation film is a silicon nitride film, wherein a thickness of the passivation film is 80~100 nm.

4. The method according to claim 2, wherein in step (b), a laser for laser grooving is an ultraviolet picosecond laser or an ultraviolet nanosecond laser.

5. The method according to claim 4, wherein in the step (b), a laser beam of the laser for laser grooving is a top-hat beam, wherein
the laser peak power is 0.5~2 W in a process of the laser grooving.

6. The method according to claim 4, wherein in the step (b), a grooving width of a finger in the grid line pattern formed after the laser grooving is 10~15µm; and a grooving depth in the grid line pattern formed after the laser grooving is 80~100 nm.

7. The method according to claim 4, wherein in the step (b), an auxiliary gas for the laser grooving is any one selected from nitrogen, argon and helium.

8. The method according to claim 1, wherein the thermal repair treatment comprises following steps:
placing the double-sided grooved silicon matrix of the TOPCon solar cell with the front side upward in an atmosphere of protective gas for the thermal repair treatment,
preferably, the protective gas is any one of nitrogen, argon and helium,
preferably, a flow rate of the protective gas is 20~30 L/min, and
preferably, a temperature of the thermal repair treatment is 600~800°C; and a duration of the thermal repair treatment is 120~180 s.

9. The method according to claim 1, wherein the protective gas is nitrogen,
preferably, a flow rate of the nitrogen is 10~15 L/min.

10. The method according to claim 1, wherein a light radiation intensity of the light injection treatment is 10~30 sun; a duration of the light injection treatment is 60~120 s; and a light source of the light injection process is white light and/or infrared light.

## Patentansprüche

1. Verfahren zur Herstellung eines TOPCon-Solarzellensubstrats, **dadurch gekennzeichnet, dass** es Folgendes umfasst:
Bereitstellen einer beidseitig gerillten Siliziummatrix einer TOPCon-Solarzelle;
Durchführen einer thermischen Reparaturbehandlung an der Siliziummatrix; und
Durchführen einer Lichtinjektionsbehandlung jeweils an einer Vorderseite und einer Rückseite der Siliziummatrix nach der thermischen Reparaturbehandlung, wodurch das TOPCon-Solarzellensubstrat erhalten wird;
wobei die Lichtinjektionsbehandlung die folgenden Schritte umfasst:
zunächst Ausrichten einer Seite der Siliziummatrix nach der thermischen Reparaturbehandlung nach oben und Anordnen derselben in einer Schutzgasatmosphäre für die Lichtinjektionsbehandlung; anschließendes Umdrehen derselben, um die andere Seite nach oben auszurichten, und Anordnen derselben in einer Schutzgasatmosphäre für die Lichtinjektionsbehandlung, um ein behandeltes TOPCon-Solarzellensubstrat zu erhalten; und
wobei während der Lichtinjektionsbehandlung eine Erwärmung erforderlich ist; und eine Erwärmungstemperatur 200~300°C beträgt.

2. Verfahren nach Anspruch 1, wobei die beidseitig gerillte Siliziummatrix der TOPCon-Solarzelle durch die folgenden Schritte hergestellt wird:
(a) Abscheiden eines Passivierungsfilms auf Oberflächen der Siliziummatrix der TOPCon-Solarzelle, um Beschichtungsschichten zu bilden; und
(b) Entfernen der Beschichtungsschichten auf der Vorderseite und der Rückseite der Siliziummatrix unter Verwendung eines Laser-Rillverfahrens und Bilden eines Gitterlinienmusters auf den Oberflächen der Beschichtungsschichten.

3. Verfahren nach Anspruch 2, wobei in Schritt (a) der Passivierungsfilm ein Siliziumnitridfilm ist, wobei eine Dicke des Passivierungsfilms 80~100 nm beträgt.

4. Verfahren nach Anspruch 2, wobei in Schritt (b) ein Laser für das Laser-Rillen ein Ultraviolett-Pikosekundenlaser oder ein Ultraviolett-Nanosekundenlaser ist.

5. Verfahren nach Anspruch 4, wobei in Schritt (b) ein Laserstrahl des Lasers für das Laser-Rillen ein Top-Hat-Strahl ist,
wobei die Laserspitzenleistung bei einem Vorgang des Laser-Rillens 0,5~2 W beträgt.

6. Verfahren nach Anspruch 4, wobei in Schritt (b) eine Rillenbreite eines Fingers in dem nach dem Laser-Rillen gebildeten Gitterlinienmuster 10~15 µm beträgt; und eine Rillentiefe in dem nach dem Laser-Rillen gebildeten Gitterlinienmuster 80~100 nm beträgt.

7. Verfahren nach Anspruch 4, wobei in Schritt (b) ein Hilfsgas für das Laser-Rillen eines ist, das aus Stickstoff, Argon und Helium ausgewählt ist.

8. Verfahren nach Anspruch 1, wobei die thermische Reparaturbehandlung die folgenden Schritte umfasst:
Anordnen der beidseitig gerillten Siliziummatrix der TOPCon-Solarzelle mit der Vorderseite nach oben in einer Schutzgasatmosphäre für die thermische Reparaturbehandlung,
wobei das Schutzgas vorzugsweise eines von Stickstoff, Argon und Helium ist,
wobei vorzugsweise eine Durchflussrate des Schutzgases 20~30 L/min beträgt, und
wobei vorzugsweise eine Temperatur der thermischen Reparaturbehandlung 600~800°C beträgt; und eine Dauer der thermischen Reparaturbehandlung 120~180 s beträgt.

9. Verfahren nach Anspruch 1, wobei das Schutzgas Stickstoff ist, wobei vorzugsweise eine Durchflussrate des Stickstoffs 10~15 L/min beträgt.

10. Verfahren nach Anspruch 1, wobei eine Lichtstrahlungsintensität der Lichtinjektionsbehandlung 10~30 Sonnen beträgt; eine Dauer der Lichtinjektionsbehandlung 60~120 s beträgt; und eine Lichtquelle des Lichtinjektionsprozesses weißes Licht und/oder Infrarotlicht ist.

## Revendications

1. Procédé de préparation d'un substrat de cellule solaire TOPCon, **caractérisé en ce qu'**il comprend :
la fourniture d'une matrice de silicium rainurée sur les deux faces d'une cellule solaire TOPCon ;
la réalisation d'un traitement de réparation thermique sur la matrice de silicium ; et
la réalisation d'un traitement d'injection de lumière respectivement sur une face avant et une face arrière de la matrice de silicium après le traitement de réparation thermique, obtenant ainsi le substrat de cellule solaire TOPCon ;
le traitement d'injection de lumière comprend les étapes suivantes :
le fait de placer, tout d'abord, une face de la matrice de silicium après le traitement de réparation thermique orientée vers le haut, et de la placer dans une atmosphère de gaz protecteur pour le traitement d'injection de lumière ; puis, de la retourner pour placer l'autre face orientée vers le haut, et de la placer dans une atmosphère de gaz protecteur pour le traitement d'injection de lumière, afin d'obtenir un substrat de cellule solaire TOPCon traité ; et
un chauffage est nécessaire pendant le traitement d'injection de lumière ; et une température de chauffage est de 200~300°C.

2. Procédé selon la revendication 1, dans lequel la matrice de silicium rainurée sur les deux faces de la cellule solaire TOPCon est préparée par les étapes suivantes :
(a) dépôt d'un film de passivation sur les surfaces de la matrice de silicium de la cellule solaire TOPCon afin de former des couches de revêtement ; et
(b) élimination des couches de revêtement sur la face avant et la face arrière de la matrice de silicium au moyen d'un procédé de rainurage au laser, et formation d'un motif de lignes de grille sur les surfaces des couches de revêtement.

3. Procédé selon la revendication 2, dans lequel, à l'étape (a), le film de passivation est un film de nitrure de silicium, dans lequel une épaisseur du film de passivation est de 80~100 nm.

4. Procédé selon la revendication 2, dans lequel, à l'étape (b), un laser destiné au rainurage au laser est un laser ultraviolet picoseconde ou un laser ultraviolet nanoseconde.

5. Procédé selon la revendication 4, dans lequel, à l'étape (b), un faisceau laser du laser destiné au rainurage au laser est un faisceau à profil plat, dans lequel :
la puissance de crête du laser est de 0,5~2 W au cours du rainurage au laser.

6. Procédé selon la revendication 4, dans lequel, à l'étape (b), une largeur de rainurage d'un doigt dans le motif de lignes de grille formé après le rainurage au laser est de 10~15 µm ; et une profondeur de rainurage dans le motif de lignes de grille formé après le rainurage au laser est de 80~100 nm.

7. Procédé selon la revendication 4, dans lequel, à l'étape (b), un gaz auxiliaire destiné au rainurage au laser est l'un quelconque choisi parmi l'azote, l'argon et l'hélium.

8. Procédé selon la revendication 1, dans lequel le traitement de réparation thermique comprend les étapes suivantes :
placement de la matrice de silicium rainurée sur les deux faces de la cellule solaire TOPCon avec la face avant orientée vers le haut dans une atmosphère de gaz protecteur pour le traitement de réparation thermique,
de préférence, le gaz protecteur est l'un quelconque parmi l'azote, l'argon et l'hélium,
de préférence, un débit du gaz protecteur est de 20~30 L/min, et
de préférence, une température du traitement de réparation thermique est de 600~800°C ; et une durée du traitement de réparation thermique est de 120~180 s.

9. Procédé selon la revendication 1, dans lequel le gaz protecteur est de l'azote, de préférence, un débit de l'azote est de 10~15 L/min.

10. Procédé selon la revendication 1, dans lequel une intensité de rayonnement lumineux du traitement d'injection de lumière est de 10~30 soleils ; une durée du traitement d'injection de lumière est de 60~120 s ; et une source lumineuse du procédé d'injection de lumière est une lumière blanche et/ou une lumière infrarouge.
